# FASCICULE DE BREVET EUROPEEN

(11) **EP 3 347 916 B1**
(45) Date de publication et mention de la délivrance du brevet: **14.08.2019**
(21) Numéro de dépôt: 16775295.5
(22) Date de dépôt: 09.09.2016
(51) Int. Cl.: H01L 31/103, H01L 31/173, H01L 27/15, H01L 33/08, H01L 33/18, H01L 33/24, H01L 33/38

(54) **DISPOSITIF ELECTROLUMINESCENT A CAPTEUR DE LUMIERE INTEGRE**
ELEKTROLUMINESZENTE VORRICHTUNG MIT INTEGRIERTEM LICHTSENSOR
ELECTROLUMINESCENT DEVICE WITH INTEGRATED LIGHT SENSOR

(30) Priorité: 10.09.2015 FR 1558407
(43) Date de publication de la demande: 18.07.2018
(73) Titulaire: Aledia, 38040 Grenoble (FR)
(72) Inventeur: DUPONT, Tiphaine, 38000 Grenoble (FR); DORNEL, Erwan, 38800 Champagnier (FR)
(74) Mandataire: Cabinet Beaumont
(86) Numéro de dépôt international: PCT/FR2016/052276
(87) Numéro de publication internationale: WO 2017/042513

(56) Documents cités:
- WO-A1-2015/016216
- FR-A1- 2 896 944
- JP-A- 2006 278 368
- JP-B2- 2 879 971
- US-A1- 2003 030 808
- US-A1- 2011 079 796
- US-A1- 2015 108 508

## Description

La présente demande de brevet revendique la priorité de la demande de brevet français FR15/58407.

### Domaine

La présente invention concerne de façon générale les dispositifs électroluminescents à base de matériaux semiconducteurs et leurs procédés de fabrication. Par dispositifs électroluminescents, on entend des dispositifs adaptés à effectuer la conversion d'un signal électrique en un rayonnement électromagnétique.

### Exposé de l'art antérieur

Pour certaines applications, il est souhaitable de mesurer le rayonnement émis par un dispositif électroluminescent. C'est le cas notamment pour réaliser des tests au cours de la fabrication du dispositif électroluminescent ou lorsque le dispositif électroluminescent est en fonctionnement. La mesure du rayonnement émis par un dispositif électroluminescent peut être réalisée au moyen d'un capteur de lumière, comprenant au moins une photodiode, distincte du dispositif électroluminescent, ce qui entraîne un surcoût. En outre, pour réaliser une mesure en continu de la lumière, le capteur de lumière doit généralement être placé dans le champ d'émission du dispositif électroluminescent et, de ce fait, bloquer une partie du flux lumineux qui serait perçu par un observateur, ce qui n'est pas souhaitable.

Il serait souhaitable de pouvoir réaliser le capteur de lumière de façon intégrée avec le dispositif électroluminescent. Ceci permettrait de mesurer facilement le rayonnement émis par le dispositif électroluminescent à des instants voulus, et notamment de façon continue.

La demande de brevet WO2014/154657 décrit un dispositif optoélectronique comprenant un capteur de lumière intégré. Le dispositif optoélectronique comprend des diodes électroluminescentes ayant la forme de nanofils semiconducteurs. Certains des fils, normalement utilisés pour réaliser des diodes électroluminescentes, sont modifiés pour former le capteur de lumière.

Un inconvénient du dispositif optoélectronique décrit dans la demande de brevet WO2014/154657 est qu'il utilise les mêmes couches de puits quantiques pour l'émission et la détection. Ces couches sont transparentes aux longueurs d'ondes plus grandes que la longueur d'onde d'émission et ne sont donc pas adaptées à la détection de telles longueurs d'onde. Un autre inconvénient est que le capteur de lumière ne permet pas de dissocier différentes longueurs d'onde, et ne permet donc pas, par exemple, la détermination de la couleur du rayonnement émis par le dispositif optoélectronique.

Des dispositifs électroluminescents permettant de mesurer facilement le rayonnement émis, et en particulier son point de couleur, sont divulgués par US 2011/079796 A1, FR 2 896 944 A1 et JP 2006 278368 A.

### Résumé

Ainsi, un objet d'un mode de réalisation est de pallier au moins en partie les inconvénients des dispositifs électroluminescents à capteur de lumière intégré décrits précédemment et de leurs procédés de fabrication.

Un autre objet d'un mode de réalisation est que le capteur de lumière est adapté à détecter la couleur du rayonnement fourni par le dispositif optoélectronique.

Un autre objet d'un mode de réalisation est que le dispositif optoélectronique est adapté à modifier et/ou réguler la couleur du rayonnement fourni par les diodes électroluminescentes à partir des signaux fournis par le capteur de lumière. Dans la description suivante, seuls les modes de réalisation expressément définis comme faisant partie de l'invention se rapportent à l'invention, et les autres modes de réalisation ne sont que des exemples utiles à l'exposé de l'invention. L'invention est définie par les revendications.

Ainsi, un mode de réalisation selon l'invention prévoit un dispositif électroluminescent selon la revendication 1.

Selon un mode de réalisation, chaque élément semiconducteur tridimensionnel est majoritairement en un composé choisi parmi le groupe comprenant les composés III-V et les composés II-VI.

Selon un mode de réalisation, le substrat est, au moins en partie, en un matériau semiconducteur choisi parmi le groupe comprenant le silicium, le germanium, le carbure de silicium, les composés III-V ou le ZnO.

Selon un mode de réalisation, le substrat comprend une deuxième face opposée à la première face, le dispositif électroluminescent comprenant une première électrode au contact de la deuxième face ou de la première face.

Selon un mode de réalisation, le dispositif comprend une deuxième électrode au contact au moins de certaines des diodes électroluminescentes et une troisième électrode au contact de la région semiconductrice du côté de la première face.

Selon l'invention, la région semiconductrice est recouverte d'un filtre coloré.

Selon un mode de réalisation, les diodes électroluminescentes sont recouvertes d'une couche comprenant des luminophores et la région semiconductrice n'est pas recouverte de ladite couche comprenant les luminophores.

Selon l'invention, les éléments semiconducteurs sont des nanofils, des microfils et/ou des structures pyramidales de taille nanométrique ou micrométrique.

Selon un mode de réalisation, la région semiconductrice est formée par implantation ionique de dopants.

Selon un mode de réalisation, la région semiconductrice est formée par épitaxie.

Selon l'invention, les diodes électroluminescentes sont réparties en ensembles de diodes électroluminescentes, le dispositif électroluminescent comprenant, pour au moins certains des ensembles, au moins deux régions semiconductrices formant des première et deuxième photodiodes, chacune des deux régions semiconductrices étant au moins partiellement dopée d'un deuxième type de conductivité opposé au premier type de conductivité et s'étendant dans le substrat depuis une deuxième partie de la première face distincte de la première partie.

Selon l'invention, les première et deuxième photodiodes ont des profondeurs de jonctions différentes et/ou sont recouvertes par des filtres de couleurs différents.

Selon un mode de réalisation, les diodes électroluminescentes sont réparties en ensembles de diodes électroluminescentes, ladite région semiconductrice étant située entre les deux ensembles.

Selon un mode de réalisation, le dispositif comprend un circuit de traitement de premiers signaux fournis par la photodiode et un circuit de commande des diodes électroluminescentes à partir de seconds signaux fournis par le circuit de traitement.

Selon un mode de réalisation, le circuit de commande est adapté, dans une phase d'étalonnage, à allumer successivement chaque ensemble de diodes électroluminescentes, le circuit de traitement étant adapté à mesurer le rayonnement capté par la photodiode lorsque chaque ensemble de diodes électroluminescentes est allumé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un mode de réalisation d'un dispositif électroluminescent à microfils ou nanofils ;
les figures 2 à 5 sont des vues de dessus, partielles et schématiques, de dispositifs optoélectroniques représentant des agencements de diodes électroluminescentes et d'une photodiode ;
les figures 6 à 8 sont des coupes, partielles et schématiques, d'autres modes de réalisation d'un dispositif électroluminescent à microfils ou nanofils ;
les figures 9 et 10 sont des vues de dessus, partielles et schématiques, de dispositifs optoélectroniques représentant des agencements de diodes électroluminescentes et de photodiodes ;
la figure 11 est une coupe, partielle et schématique, d'un autre mode de réalisation d'un dispositif électroluminescent à microfils ou nanofils ;
la figure 12 est une vue de dessus, partielle et schématique, du dispositif optoélectronique de la figure 11 ; et
la figure 13 est un schéma électrique d'un mode de réalisation d'un dispositif électroluminescent.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs électroluminescents décrits ci-après sont à la portée de l'homme de l'art et ne sont pas décrits. Dans la suite de la description, sauf indication contraire, les termes "sensiblement", "environ" et "de l'ordre de" signifient "à 10 % près". Par ailleurs, dans la présente description, on utilise le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.).

La présente description concerne des dispositifs électroluminescents comprenant des éléments semiconducteurs ayant la forme de microfils, de nanofils ou de pyramides.

Le terme "microfil" ou "nanofil" désigne une structure tridimensionnelle de forme allongée, par exemple cylindrique, conique ou tronconique, selon une direction privilégiée dont au moins deux dimensions, appelées dimensions mineures, sont comprises entre 50 nm et 2,5 µm, de préférence entre 300 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 300 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil. La base du fil a, par exemple, une forme ovale, circulaire ou polygonale, notamment triangulaire, rectangulaire, carrée ou hexagonale.

Dans la suite de la description, le terme pyramide ou pyramide tronquée désigne une structure tridimensionnelle de forme pyramidale. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

Dans la suite de la description, des modes de réalisation vont être décrits dans le cas d'un dispositif électroluminescent à diodes électroluminescentes comprenant des éléments semiconducteurs ayant la forme de microfils ou de nanofils.

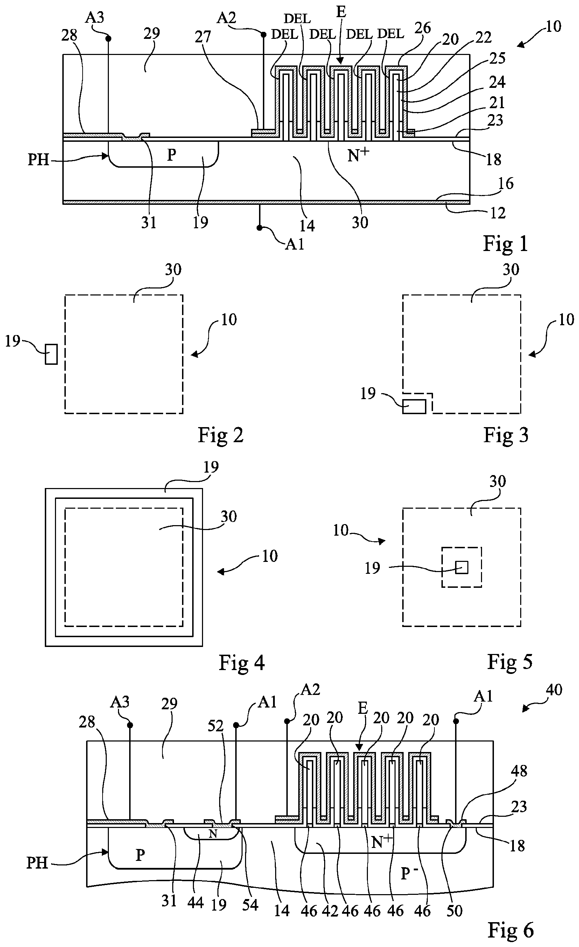

La figure 1 est une coupe, partielle et schématique, d'un dispositif électroluminescent 10 réalisé à partir de fils tels que décrits précédemment et adapté à émettre un rayonnement électromagnétique.

Le dispositif 10 comprend, du bas vers le haut en figure 1 :
une première électrode de polarisation 12 ;
un substrat 14, par exemple semiconducteur, dopé d'un premier type de conductivité, par exemple dopé de type N, et comprenant des faces parallèles 16 et 18, la face 16 étant au contact de l'électrode 12 ;
au moins une région semiconductrice 19 formée dans le substrat 14, dopée ou partiellement dopée d'un deuxième type de conductivité opposé au premier type de conductivité, par exemple dopée de type P, et s'étendant dans le substrat 14 depuis la face 18 sur une partie de l'épaisseur du substrat 14 ;
des éléments semiconducteurs 20, qui dans le présent mode de réalisation correspondent à des fils, cinq fils 20 d'axe parallèles étant représentés, chaque fil 20 comprenant une portion inférieure 21 du premier type de conductivité se prolongeant par une portion supérieure 22 du premier type de conductivité, la portion inférieure 21 reposant sur le substrat 14 et étant éventuellement en contact avec le substrat 14 ou séparée du substrat 14 par une portion de germination non représentée en figure 1 ;
une couche isolante électriquement 23 recouvrant la périphérie de la portion inférieure 21 de chaque fil 20 et recouvrant la face 18 entre les fils 20 ;
une coque 25 recouvrant la paroi extérieure 24 de la portion supérieure 22 de chaque fil 20, la coque 25 comprenant au moins un empilement d'une couche active recouvrant la portion supérieure 22 et d'une couche semiconductrice du deuxième type de conductivité recouvrant la couche active ;
une couche de seconde électrode 26 recouvrant chaque coque 25 ;
une couche conductrice et réfléchissante 27, s'étendant sur la couche de seconde électrode 26 entre les fils 20 mais ne s'étendant pas sur les fils 20 ;
une troisième électrode 28 en contact avec la région semiconductrice 19 au travers d'une ouverture 31 prévue dans la couche isolante 23 ; et
éventuellement, une couche d'encapsulation 29 recouvrant l'ensemble de la structure.

Selon un autre mode de réalisation, la coque 25 peut recouvrir au moins en partie la portion inférieure 21 ainsi que la portion supérieure 22 de chaque fil 20. Dans ce cas, la couche isolante électriquement 23 recouvre la partie inférieure de la coque 25.

Le dispositif optoélectronique 10 peut, en outre, comprendre une couche de luminophores, non représentée, prévue sur la couche d'encapsulation 29 ou confondue avec celle-ci. Les luminophores sont adaptés, lorsqu'ils sont excités par la lumière émise par les diodes électroluminescentes, à émettre de la lumière à une longueur d'onde différente de la longueur d'onde de la lumière émise par les diodes électroluminescentes. A titre d'exemple, les diodes électroluminescentes sont adaptées à émettre de la lumière bleue et les luminophores sont adaptés à émettre de la lumière jaune lorsqu'ils sont excités par la lumière bleue. De ce fait, un observateur perçoit une lumière correspondant à une composition des lumières bleue et jaune et qui, selon la proportion de chaque lumière, peut être sensiblement blanche. La couleur finale perçue par l'observateur est caractérisée par ses coordonnées chromatiques telles que définies par les normes de la Commission Internationale de l'Eclairage.

Le dispositif optoélectronique 10 peut, en outre, comprendre une couche transparente disposée sur la couche de luminophores. Le dispositif optoélectronique 10 peut, en outre, comprendre un élément diffusant sur la couche de luminophores ou sur la couche transparente permettant de renvoyer une partie de la lumière vers la photodiode.

L'ensemble formé par un fil 20 et la coque 25 constitue une diode électroluminescente DEL. Lorsque plusieurs diodes électroluminescentes DEL sont formées sur le substrat 14, elles peuvent être connectées en série et/ou en parallèle et former un ensemble de diodes électroluminescentes. L'ensemble peut comprendre de quelques diodes électroluminescentes DEL à quelques milliers de diodes électroluminescentes DEL. A titre d'exemple, en figure 1, les diodes électroluminescentes DEL forment un groupe E de cinq diodes électroluminescentes DEL montées en parallèle.

La jonction entre la région semiconductrice 19 dopée de type P et la partie dopée de type N du substrat 14, s'étendant autour de la région 19, forme une photodiode PH. La couche d'encapsulation 29 recouvre, de préférence, les diodes électroluminescentes DEL et la photodiode PH.

La première électrode 12 est reliée à un noeud A1, la deuxième électrode 26 est reliée à un noeud A2 et la troisième électrode 28 est reliée à un noeud A3. En fonctionnement, la tension appliquée entre les électrodes 12 et 26 est telle que chaque diode électroluminescente DEL est passante de façon que la couche active de chaque diode électroluminescente DEL émette un rayonnement lumineux. Une partie du rayonnement émis par les couches actives des diodes électroluminescentes DEL peut être captée par la photodiode PH. Etant donné que le rapport entre la puissance lumineuse captée par chaque photodiode PH et la puissance lumineuse émise par les diodes électroluminescentes DEL avoisinantes peut être connu, le signal fourni par chaque photodiode PH est donc représentatif de la puissance lumineuse émise par les diodes électroluminescentes DEL.

Selon un mode de réalisation, les photodiodes PH sont polarisées en inverse. Le courant inverse de chaque photodiode PH dépend alors du rayonnement lumineux capté par la photodiode PH. Dans le mode de réalisation représenté en figure 1, cela signifie que le potentiel au noeud A3 est inférieur au potentiel au noeud A1. Selon un autre mode de réalisation, les photodiodes PH sont polarisées en direct. Les photodiodes PH peuvent alors être utilisées comme capteur de température.

La photodiode PH est formée par une jonction entre des régions d'un matériau semiconducteur ayant des dopages différents.

Les fils 20 sont formés sur une zone 30 de la face 18 du substrat 14 et la région semiconductrice 19 est formée en dehors de cette zone 30. En particulier, la région semiconductrice 19 ne s'étend pas entre les fils 20. De préférence, la distance minimale entre le bord de la région semiconductrice 19 et la base du fil 20 le plus proche est supérieure à 1 µm.

Les figures 2 à 5 représentent des vues de dessus schématiques du dispositif optoélectronique 10 dans lesquelles on a représenté le contour de la région 30 sur laquelle est formé l'ensemble E de diodes électroluminescentes par une ligne à tirets courts et dans lesquelles on a représenté le contour de la région semiconductrice 19 par une ligne continue.

En figure 2, la photodiode PH est disposée le long d'un bord de l'ensemble E de diodes électroluminescentes. La photodiode PH peut être disposée le long de tout ou partie d'un bord de l'ensemble E de diodes électroluminescentes. En figure 3, l'ensemble E de diodes électroluminescentes peut être réalisé sur une surface comprenant un évidement sur un bord dans lequel est réalisée la photodiode PH. Ceci permet avantageusement de réduire la surface des espaces morts sur la tranche de circuit intégré sur laquelle est formé le dispositif optoélectronique 10. En figure 4, la photodiode PH est disposée tout autour de l'ensemble E de diodes électroluminescentes. Le signal mesuré par la photodiode PH permet alors avantageusement la détermination du rayonnement émis sur la totalité de la périphérie de l'ensemble E de diodes électroluminescentes. En figure 5, l'ensemble E de diodes électroluminescentes est disposé autour de la photodiode PH. Le signal mesuré par la photodiode PH est alors avantageusement peu perturbé par des rayonnements électromagnétiques extérieurs.

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V qui n'est pas transparent à la longueur d'émission des diodes électroluminescentes, tel que du InGaN ou du GaAs. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator). L'épaisseur du substrat 14 est, par exemple, comprise entre 10 µm et 1,5 mm.

Le substrat 14 est dopé du premier type de conductivité au moins sur une partie de son épaisseur depuis la face 18. Lorsque le substrat 14 est monobloc, il peut être dopé de façon uniforme. A titre de variante, le substrat 14 peut comprendre une région dopée du premier type de conductivité s'étendant depuis la face 18 dans l'épaisseur du substrat 14, seulement sur une partie de l'épaisseur du substrat 14, et reposant sur une région moins fortement dopée ou non dopée. Le substrat 14 est, par exemple, un substrat dopé du premier type de conductivité avec une concentration de dopants comprise entre 1^{∗}10¹⁵ atomes/cm³ et 2^{∗}10²⁰ atomes/cm³, de préférence comprise entre 5^{∗}10¹⁷ atomes/cm³ et 5^{∗}10¹⁹ atomes/cm³, par exemple environ 3^{∗}10¹⁸ atomes/cm³. Dans le cas d'un substrat 14 de silicium, des exemples de dopants de type P sont le bore (B) ou l'indium (In) et des exemples de dopants de type N sont le phosphore (P), l'arsenic (As), ou l'antimoine (Sb) . La face 18 du substrat 10 de silicium peut être une face (100) ou une face (111).

La région semiconductrice 19 peut avoir une profondeur, mesurée depuis la face 18, comprise entre 200 nm et 4 µm, de préférence comprise entre 400 nm et 800 nm. La région 19 est, par exemple, dopée du deuxième type de conductivité avec une concentration de dopants comprise entre 5^{∗}10¹⁶ atomes/cm³ et 1^{∗}10²² atomes/cm³, de préférence comprise entre 5^{∗}10¹⁷ atomes/cm³ et 5^{∗}10¹⁹ atomes/cm³, par exemple environ 6^{∗}10¹⁸ atomes/cm³.

Selon un mode de réalisation, la région semiconductrice 19 et la région semiconductrice 44, décrite par la suite, peuvent être formées par implantation ionique de dopants. La profondeur d'implantation peut être choisie en fonction de la longueur d'onde à détecter, ce qui permet d'avoir un capteur sélectif à la couleur. Selon un autre mode de réalisation, la région semiconductrice 19 et la région semiconductrice 44 peuvent être formées par épitaxie. Selon un mode de réalisation, la région semiconductrice 19 et la région semiconductrice 44 sont réalisées par au moins une étape d'implantation, qui peut être mise en oeuvre avant la formation des fils 20 et des coques 25 ou après la formation des fils 20 et des coques 25. De préférence, la région semiconductrice 19 est réalisée par au moins une étape d'implantation mise en oeuvre après la formation des fils 20 et des coques 25. Ceci permet d'éviter une diffusion des dopants depuis la région semiconductrice 19 lors des étapes de formation des diodes électroluminescentes DEL. Lorsque la région semiconductrice 19 est réalisée par au moins une étape d'implantation mise en oeuvre après la formation des fils 20 et des coques 25, les fils 20 et les coques 25 peuvent être recouverts par une couche diélectrique de protection.

Selon un autre mode de réalisation, la région semiconductrice 19 peut se diviser en plusieurs sous-régions semiconductrices non dopées ou dopées du deuxième type de conductivité, avec une concentration de dopants qui diminue en s'éloignant de la face 18, de façon à améliorer le contact électrique entre la région semiconductrice 19 et la troisième électrode 28 à travers l'ouverture 31 et pour améliorer le rendement de la photodiode. Dans ce cas, la région semiconductrice 19 peut être réalisée par plusieurs étapes d'implantation.

La première électrode 12 peut correspondre à une couche conductrice qui s'étend sur la face 16 du substrat 14. Le matériau formant l'électrode 12 est, par exemple, du siliciure de nickel (NiSi), de l'aluminium (Al), du siliciure d'aluminium (AlSi), du titane (Ti), du cuivre (Cu), du siliciure de tungstène (WSi₂) ou du siliciure de titane (TiSi). La troisième électrode 28 peut avoir la même composition que la première électrode 12.

La couche isolante 23 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, l'épaisseur de la couche isolante 23 est comprise entre 5 nm et 300 nm, par exemple égale à environ 100 nm. La couche isolante 23 peut avoir une structure monocouche ou correspondre à un empilement de deux couches ou de plus de deux couches.

Les éléments semiconducteurs 20 sont, au moins en partie, formés à partir d'au moins un matériau semiconducteur. Le matériau semiconducteur est choisi parmi le groupe comprenant les composés III-V, les composés II-VI ou les semiconducteurs ou composés du groupe IV.

Les éléments semiconducteurs 20 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les éléments semiconducteurs 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les éléments semiconducteurs 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

Lorsque les éléments semiconducteurs tridimensionnels 20 du dispositif optoélectronique correspondent à des fils, la hauteur totale de chaque fil peut être comprise entre 250 nm et 50 µm. Chaque fil 20 peut avoir une structure semiconductrice allongée selon un axe sensiblement perpendiculaire à la face 18. Chaque fil 20 peut avoir une forme générale cylindrique, dont la base a, par exemple, une forme ovale, circulaire ou polygonale, notamment triangulaire, rectangulaire, carrée ou hexagonale. Les axes de deux fils 20 adjacents peuvent être distants de 0,5 µm à 10 µm et de préférence de 1,5 µm à 5 µm. A titre d'exemple, les fils 20 peuvent être régulièrement répartis, notamment selon un réseau hexagonal.

Selon un mode de réalisation, la portion inférieure 21 de chaque fil est principalement constituée d'un composé III-N, par exemple du nitrure de gallium, dopé d'un premier type de conductivité, par exemple de type N. Le dopant de type N peut être le silicium. La hauteur de la portion inférieure 21 peut être comprise entre 200 nm et 25 µm.

Selon un mode de réalisation, la portion supérieure 22 de chaque fil est, par exemple, au moins partiellement réalisée dans un composé III-N, par exemple du nitrure de gallium. La portion 22 peut être dopée du premier type de conductivité, par exemple de type N, ou ne pas être dopée de façon intentionnelle. La hauteur de la portion 22 peut être comprise entre 500 nm et 25 µm.

A titre de variante, pour chaque fil 20, la couche isolante 23 peut s'étendre sur une partie de la portion supérieure 22, ne pas s'étendre sur la totalité de la portion inférieure 21 ou s'étendre sur une partie de la coque 25. A titre de variante, la coque 25 peut s'étendre sur toute ou partie de la portion inférieure 21.

Lorsque les éléments semiconducteurs tridimensionnels 20 du dispositif optoélectronique 10 correspondent à des pyramides, la hauteur de chaque pyramide peut être comprise entre 100 nm et 25 µm. Chaque pyramide peut avoir une structure semiconductrice allongée selon un axe sensiblement perpendiculaire à la face 18. La base de chaque pyramide peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et de préférence de 1,5 µm à 5 µm. A titre d'exemple, les pyramides peuvent être régulièrement réparties, notamment selon un réseau hexagonal.

Dans le cas d'un fil 20 composé principalement de GaN, la structure cristalline du fil peut être du type wurtzite, le fil s'étendant selon la direction cristallographique c.

La couche active de la coque 25 est la couche depuis laquelle est émise la majorité du rayonnement fourni par le dispositif 10. La couche active peut comporter des moyens de confinement. A titre d'exemple, la couche peut comprendre un puits quantique unique ou des puits quantiques multiples.

La deuxième électrode 26 est adaptée à polariser la couche active recouvrant chaque fil 20 et à laisser passer le rayonnement électromagnétique émis par les diodes électroluminescentes DEL. Le matériau formant la deuxième électrode 26 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 26 a une épaisseur comprise entre 5 nm et 200 nm, de préférence entre 20 nm et 50 nm.

La couche d'encapsulation 29 peut être réalisée en un matériau inorganique au moins partiellement transparent.

A titre d'exemple, le matériau inorganique est choisi parmi le groupe comprenant les oxydes de silicium du type SiOₓ où x est un nombre réel compris entre 1 et 2 ou SiO_{y}N_{z} où y est un nombre réel compris entre 0 et 2 et où z est un nombre réel compris entre 0 et 1 et les oxydes d'aluminium, par exemple Al₂O₃. Le matériau inorganique peut alors être déposé par CVD basse température, notamment à une température inférieure à 300°C-400°C, par exemple par PECVD (acronyme anglais pour Plasma Enhanced Chemical Vapor Déposition).

La couche d'encapsulation 29 peut être réalisée en un matériau organique au moins partiellement transparent. A titre d'exemple, la couche d'encapsulation 29 est un polymère silicone, un polymère époxyde, un polymère acrylique ou un polycarbonate. La couche d'encapsulation 29 peut alors être déposée par un procédé de dépôt à la tournette, par un procédé d'impression par jet ou par un procédé de sérigraphie. Un procédé de dispense par doseur temps/pression ou par doseur volumétrique est également possible en mode automatique sur des équipements programmables.

Un exemple de procédé de fabrication des diodes électroluminescentes DEL est décrit dans la demande de brevet US2014/0077151.

Selon un autre mode de réalisation, chaque élément semiconducteur 20 n'est pas en contact direct avec le substrat 14 mais repose sur une portion d'un matériau favorisant la croissance des éléments semiconducteurs 20, appelée plots de germination. A titre d'exemple, le matériau composant les plots de germination peut être un nitrure, un carbure ou un borure d'un métal de transition de la colonne IV, V ou VI du tableau périodique des éléments ou une combinaison de ces composés. A titre d'exemple, les plots de germination peuvent être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. Les plots de germination peuvent être dopés du même type de conductivité que le substrat 14. Les plots de germination ont, par exemple, une épaisseur comprise entre 1 nm et 100 nm, de préférence comprise entre 10 nm et 30 nm. A titre de variante, les plots de germination peuvent être remplacés par une couche de germination recouvrant le substrat 14 et interposée entre le substrat 14 et les éléments semiconducteurs 20.

Lorsque les plots de germination sont en nitrure d'aluminium, ils peuvent être sensiblement texturés et posséder une polarité préférentielle. La texturation des plots de germination peut être obtenue par un traitement supplémentaire réalisé après le dépôt des plots de germination. Il s'agit, par exemple, d'un recuit sous flux d'ammoniac (NH₃). Dans le cas d'un fil 20 composé principalement de GaN, chaque plot de germination peut favoriser la croissance du GaN avec la polarité N.

La figure 6 représente un autre mode de réalisation d'un dispositif électroluminescent 40. Le dispositif électroluminescent 40 comprend l'ensemble des éléments du dispositif électroluminescent 10 représenté en figure 1 avec les différences suivantes :
le substrat 14 est un substrat non dopé ou faiblement dopé du deuxième type de conductivité, par exemple de type P ;
une région semiconductrice 42, dopée du premier type de conductivité, par exemple de type N, plus fortement dopée que le substrat, s'étendant dans le substrat 14 depuis la totalité de la zone 30 de la face 18 sur laquelle reposent les fils 20 ;
une région semiconductrice 44 dopée du premier type de conductivité, par exemple dopée de type N, plus fortement dopée que le substrat, est formée dans la région semiconductrice 19 depuis la face 18 ;
la première électrode 12 est remplacée par un plot conducteur 48, relié au noeud A1, en contact avec la région semiconductrice 42 au travers d'une ouverture 50 prévue dans la couche isolante 23 et par un plot conducteur 52, relié au noeud A1, en contact avec la région semiconductrice 44 au travers d'une ouverture 54 prévue dans la couche isolante 23.

La région 42 est une région fortement dopée. De préférence, le type de conductivité de la région 42 est opposé au type de conductivité du substrat 14. A titre d'exemple, en figure 5, on a représenté un substrat 14 faiblement dopé de type P et une région 42 fortement dopée de type N. La concentration de dopants de la région 42 est comprise entre 5^{∗}10¹⁶ atomes/cm³ et 2^{∗}10²⁰ atomes/cm³, de préférence entre 3^{∗}10¹⁷ atomes/cm³ et 5^{∗}10¹⁸ atomes/cm³. L'épaisseur de la région 42 est comprise entre 150 nm et plusieurs micromètres, de préférence entre 150 nm et 1 µm, plus préférentiellement entre 250 nm et 400 nm.

La région 44 est une région fortement dopée. De préférence, le type de conductivité de la région 44 est opposé au type de conductivité du substrat 14. A titre d'exemple, en figure 6, on a représenté un substrat 14 faiblement dopé de type P et une région 44 fortement dopée de type N. La concentration de dopants de la région 44 est comprise entre 5^{∗}10¹⁶ atomes/cm³ et 2^{∗}10²⁰ atomes/cm³, de préférence entre 3^{∗}10¹⁷ atomes/cm³ et 5^{∗}10¹⁸ atomes/cm³. L'épaisseur de la région 44 est comprise entre 150 nm et plusieurs micromètres, de préférence entre 150 nm et 1 µm, plus préférentiellement entre 150 nm et 400 nm.

En figure 6, on a, en outre, représenté des plots de germination 46 sous chaque fil 20.

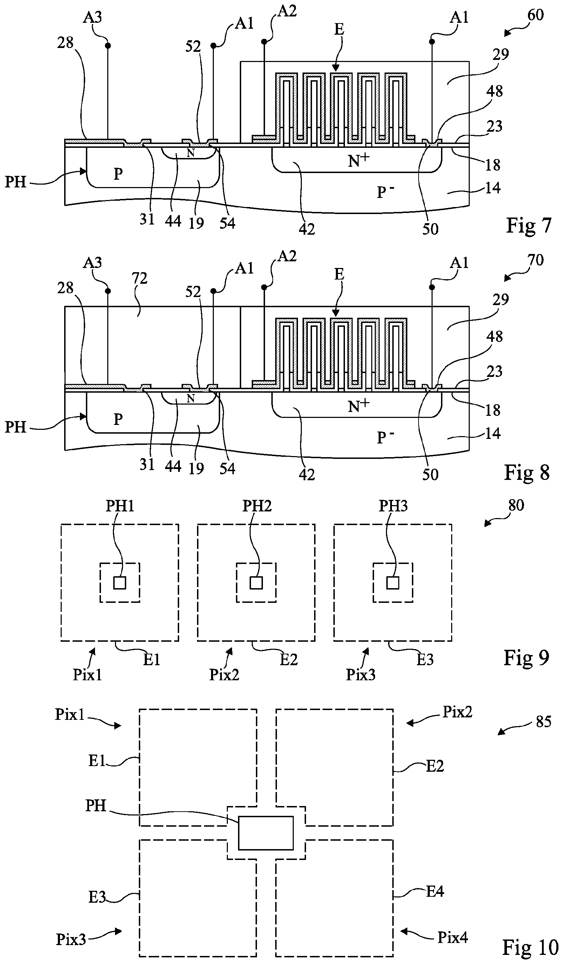

La figure 7 représente un autre mode de réalisation d'un dispositif électroluminescent 60. Le dispositif électroluminescent 60 comprend l'ensemble des éléments du dispositif électroluminescent 40 représenté en figure 6 à la différence que la couche d'encapsulation 29 ne recouvre pas la photodiode PH. Un tel mode de réalisation permet, de façon avantageuse, de capter, en plus du rayonnement fourni par l'ensemble de diodes électroluminescentes E, un rayonnement émis par une autre source lumineuse.

La figure 8 représente un autre mode de réalisation d'un dispositif électroluminescent 70. Le dispositif électroluminescent 70 comprend l'ensemble des éléments du dispositif électroluminescent 60 représenté en figure 7 et comprend, en outre, un filtre coloré 72 recouvrant la photodiode PH. Le filtre coloré 72 peut être réalisé par une couche de résine colorée. Le filtre coloré 72 permet de façon avantageuse que la photodiode PH ne détecte l'intensité que d'une portion du spectre d'émission. Dans ce but, le spectre d'absorption du filtre doit être choisi de façon à transmettre uniquement la gamme de longueurs d'onde que l'on souhaite détecter.

La figure 9 est une vue de dessus, partielle et schématique, d'un autre mode de réalisation d'un circuit optoélectronique 80 comprenant trois ensembles E1, E2 et E3 de diodes électroluminescentes et trois photodiodes PH1, PH2 et PH3. En figure 9, on a représenté le contour de la région 30 sur laquelle est formé chaque ensemble E1, E2 et E3 de diodes électroluminescentes par une ligne à tirets courts et on a représenté le contour de la région semiconductrice 19 associée à chaque photodiode PH1, PH2 et PH3 par une ligne continue. Selon un mode de réalisation, chaque ensemble E1, E2 et E3 de diodes électroluminescentes fait partie d'un pixel d'affichage Pix1, Pix2 et Pix3. Un élément opaque, non représenté, par exemple un élément réfléchissant, peut être disposé entre chaque paire de pixels adjacents. Les pixels d'affichage Pix1, Pix2 et Pix3 sont adaptés à émettre un rayonnement à des longueurs d'onde différentes. Dans ce but, selon un mode de réalisation, les compositions des couches actives des ensembles de diodes électroluminescentes E1, E2 et E3 sont différentes et adaptées pour émettre des rayonnements à des longueurs d'onde différentes. Selon un autre mode de réalisation, chaque ensemble de diodes électroluminescentes E1, E2 et E3 est recouvert d'un bloc de luminophores dont les compositions sont différentes et adaptées pour que les pixels Pix1, Pix2 et Pix3 émettent des rayonnements à des longueurs d'onde différentes. Les informations des intensités des lumières émises par les diodes électroluminescentes E1, E2 et E3 et mesurées respectivement par les photodiodes PH1, PH2 et PH3 peuvent être utilisées de façon avantageuse pour ajuster les courants d'alimentation des diodes électroluminescentes E1, E2 et E3 et ainsi faire varier la couleur perçue par un observateur de l'ensemble des diodes électroluminescentes E1, E2 et E3. Avantageusement, la couleur perçue par un observateur pourra être blanche.

La figure 10 est une vue de dessus, partielle et schématique, d'un autre mode de réalisation d'un circuit optoélectronique 85 comprenant quatre ensembles E1, E2, E3 et E4 de diodes électroluminescentes agencés sur deux rangées et deux colonnes et une photodiode PH située au centre de l'agencement des ensembles E1, E2, E3 et E4 de diodes électroluminescentes. Selon un mode de réalisation, chaque ensemble E1, E2, E3 et E4 de diodes électroluminescentes fait partie d'un pixel d'affichage Pix1, Pix2, Pix3 et Pix4. A titre d'exemple, un écran d'affichage peut être obtenu par la répétition de l'agencement représenté en figure 9 ou 10. Selon un mode de réalisation d'un procédé de mesure ou d'étalonnage de la couleur, on peut allumer chaque pixel Pix1, Pix2, Pix3 et Pix4 successivement et faire une détection par la photodiode PH unique de l'intensité émise, pour constituer le spectre global et calculer le point de couleur.

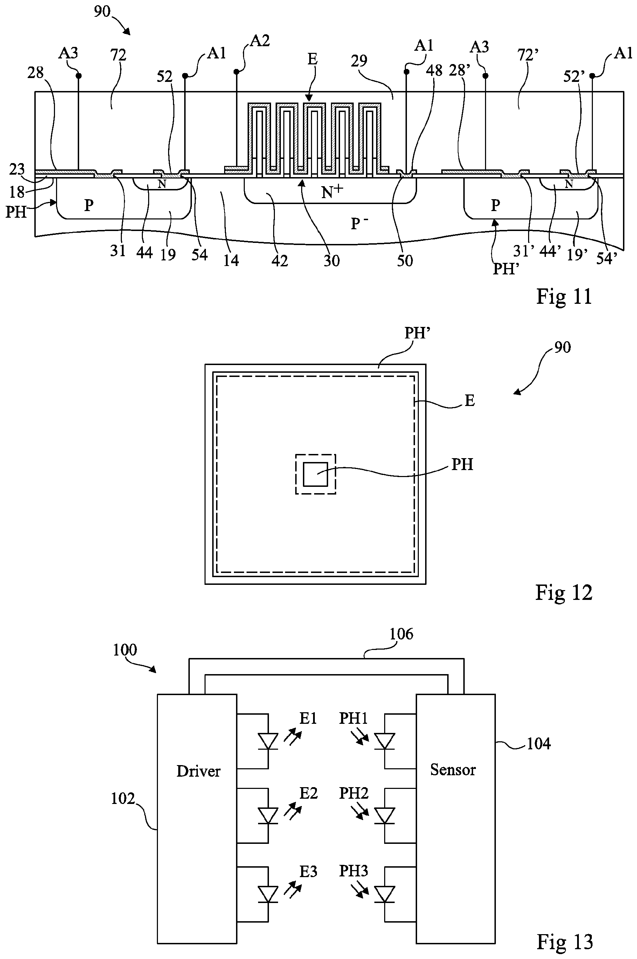

La figure 11 représente un autre mode de réalisation d'un dispositif électroluminescent 90. Le dispositif électroluminescent 90 comprend l'ensemble des éléments du dispositif électroluminescent 70 représenté en figure 8 et comprend, en outre, une photodiode supplémentaire PH' pouvant avoir une structure analogue à la photodiode PH, les éléments de la photodiode PH' étant désignés par les mêmes références que pour la photodiode PH auxquelles est ajoutée une apostrophe. Selon un mode de réalisation, la jonction de la photodiode PH' est réalisée à une profondeur différente de la photodiode PH. La photodiode PH' permet avantageusement de capter un rayonnement à une longueur d'onde différente de celle du rayonnement capté par la photodiode PH. Ceci peut être obtenu, par exemple, par une région 44' plus étendue en profondeur que la région 44. A titre d'exemple, la photodiode PH peut être adaptée pour capter principalement la lumière directement émise par l'ensemble de diodes électroluminescentes E et la photodiode PH' peut être adaptée pour capter principalement le rayonnement réémis par une couche de luminophores recouvrant l'ensemble E de diodes électroluminescentes. Selon un mode de réalisation, les photodiodes PH et PH' sont surmontées de filtres de couleur 72 et 72' différents. Les photodiodes PH et PH' peuvent ainsi être utilisées pour obtenir une estimation du spectre d'émission de l'ensemble de diodes électroluminescentes E de façon à déterminer un point de couleur pour le dispositif électroluminescent 90. Le procédé de calibration du dispositif électroluminescent 90 et le procédé de calcul du point de couleur peuvent être des procédés connus de l'homme du métier, par exemple les procédés décrits dans la publication de G. Eppeldauer, « Spectral Response Based Calibration Method of Tristimulus Colorimeters » J. Res. Natl. Inst. Stand. Technol.103, 615 (1998).

La figure 12 représente une vue de dessus schématique d'un mode de réalisation du dispositif électroluminescent 90 dans laquelle l'ensemble de diodes électroluminescentes E peut être disposé autour de la première photodiode PH et la photodiode PH' est disposée autour de l'ensemble de diodes électroluminescentes E.

La figure 13 représente un schéma électrique équivalent d'un mode de réalisation d'un dispositif électroluminescent 100 comprenant trois ensembles E1, E2, E3 de diodes électroluminescentes, trois photodiodes PH1, PH2, PH3, un circuit de commande 102 (Driver) des ensembles E1, E2, E3 de diodes électroluminescentes et un circuit de traitement 104 (Sensor) des signaux fournis par les photodiodes PH1, PH2, PH3. Le circuit de traitement 104 est adapté à échanger des données avec le circuit de commande 102 par un bus 106 d'échange de données. Les signaux fournis par le circuit de traitement 104 peuvent, par exemple, servir à la régulation de l'intensité et/ou de la couleur de la lumière émise par les ensembles E1, E2, E3 de diodes électroluminescentes via un contrôle des courants alimentant les diodes électroluminescentes.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, le mode de réalisation représenté en figure 6 dans lequel la photodiode PH n'est pas recouverte par la couche d'encapsulation 29 peut être combiné au mode de réalisation représenté en figure 1 dans lequel l'électrode 12 est située sur la face 16 du substrat 14 opposée à la face 18 sur laquelle reposent les fils 20. De même, le mode de réalisation représenté en figure 8 dans lequel la photodiode PH est recouverte d'un filtre coloré 72 peut être combiné au mode de réalisation représenté en figure 1 dans lequel l'électrode 12 est située sur la face 16 du substrat 14 opposée à la face 18 sur laquelle reposent les fils 20. L'invention est définie par les revendications, et seuls les modes de réalisation présentant en combinaison toutes tes caractéristiques de la revendication 1 sont des modes de réalisation selon l'invention.

## Revendications

1. Dispositif électroluminescent (10 ; 40 ; 60 ; 70 ; 80 ; 85 ; 90) comprenant :
un substrat (14) au moins partiellement dopé d'un premier type de conductivité et comprenant une première face (18) ;
des diodes électroluminescentes (DEL) comprenant chacune au moins un élément semiconducteur tridimensionnel (20) non dopé ou dopé du premier type de conductivité, les éléments semiconducteurs tridimensionnels (20) reposant sur une première partie (30) continue de la première face, les éléments semiconducteurs tridimensionnel (20) étant des nanofils, des microfils et/ou des structures pyramidales de taille nanométrique ou micrométrique ; et
au moins une région semiconductrice (19, 44) formant une photodiode (PH), au moins partiellement dopée d'un deuxième type de conductivité opposé au premier type de conductivité,
dans lequel les diodes électroluminescentes (DEL) sont réparties en ensembles de diodes électroluminescentes (E), le dispositif électroluminescent comprenant, pour au moins certains des ensembles (E), au moins deux régions semiconductrices (19, 44, 19', 44') formant des première et deuxième photodiodes (PH, PH'), chacune des deux régions semiconductrices étant au moins partiellement dopée d'un deuxième type de conductivité opposé au premier type de conductivité et s'étendant dans le substrat depuis une deuxième partie de la première face distincte de la première partie, **caractérisé en ce que**
la région semiconductrice (19, 44) s'étend dans le substrat depuis une deuxième partie de la première face distincte de la première partie ; **en ce que**
la région semiconductrice (19, 44) est recouverte d'un filtre coloré ; et **en ce que**
les première et deuxième photodiodes (PH, PH') ont des profondeurs de jonctions différentes et/ou sont recouvertes par des filtres de couleurs différents (72, 72').

2. Dispositif électroluminescent selon la revendication 1, dans lequel chaque élément semiconducteur tridimensionnel (20) est majoritairement en un composé choisi parmi le groupe comprenant les composés III-V et les composés II-VI.

3. Dispositif électroluminescent selon la revendication 1 ou 2, dans lequel le substrat (14) est, au moins en partie, en un matériau semiconducteur choisi parmi le groupe comprenant le silicium, le germanium, le carbure de silicium, les composés III-V ou le ZnO.

4. Dispositif électroluminescent selon l'une quelconque des revendications 1 à 3, dans lequel le substrat (14) comprend une deuxième face (16) opposée à la première face, le dispositif électroluminescent comprenant une première électrode (12 ; 48) au contact de la deuxième face (16) ou de la première face (18).

5. Dispositif électroluminescent selon la revendication 4, comprenant une deuxième électrode (26) au contact au moins de certaines des diodes électroluminescentes (DEL) et une troisième électrode (28) au contact de la région semiconductrice (19) du côté de la première face (18).

6. Dispositif électroluminescent selon l'une quelconque des revendications 1 à 5, dans lequel les diodes électroluminescentes (DEL) sont recouvertes d'une couche (29) comprenant des luminophores et dans lequel la région semiconductrice (19, 44) n'est pas recouverte de ladite couche comprenant les luminophores.

7. Dispositif électroluminescent selon l'une quelconque des revendications 1 à 6, dans lequel la région semiconductrice (19, 44) est formée par implantation ionique de dopants.

8. Dispositif électroluminescent selon l'une quelconque des revendications 1 à 6, dans lequel la région semiconductrice (19, 44) est formée par épitaxie.

9. Dispositif électroluminescent selon l'une quelconque des revendications 1 à 8, dans lequel les diodes électroluminescentes (DEL) sont réparties en ensembles de diodes électroluminescentes (E1, E2, E3, E4), ladite région semiconductrice (19, 44) étant située entre les deux ensembles.

10. Dispositif électroluminescent selon l'une quelconque des revendications 1 à 9, comprenant un circuit de traitement (104) de premiers signaux fournis par la photodiode (PH) et un circuit (102) de commande des diodes électroluminescentes (DEL) à partir de seconds signaux fournis par le circuit de traitement.

11. Dispositif électroluminescent selon la revendication 10 dans son rattachement à la revendication 9, dans lequel le circuit de commande (102) est adapté, dans une phase d'étalonnage, à allumer successivement chaque ensemble de diodes électroluminescentes (E1, E2), le circuit de traitement étant adapté à mesurer le rayonnement capté par la photodiode (PH) lorsque chaque ensemble de diodes électroluminescentes est allumé.

## Patentansprüche

1. Lichtemittierende Vorrichtung (10; 40; 60; 70; 80; 85; 90), die folgendes aufweist:
ein wenigstens teilweise dotiertes Substrat (14) eines ersten Leitfähigkeitstyps, das eine erste Oberfläche (18) aufweist;
lichtemittierende Dioden (DEL), die jeweils wenigstens ein undotiertes oder dotiertes dreidimensionales Halbleiterelement (20) vom ersten Leitfähigkeitstyp aufweisen, wobei die dreidimensionalen Halbleiterelemente (20) auf einem ersten kontinuierlichen Teil (30) der ersten Oberfläche ruhen und die dreidimensionalen Halbleiterelemente (20) Nanodrähte, Mikrodrähte und/oder Pyramidenstrukturen im Nano- oder Mikrometerbereich sind; und
wenigstens einen wenigstens teilweise dotierten Halbleiterbereich (19, 44), der eine Photodiode (PH) eines zweiten Leitfähigkeitstyps entgegengesetzt zu dem ersten Leitfähigkeitstyp bildet,
wobei die lichtemittierenden Dioden (DEL) in Anordnungen von lichtemittierenden Dioden (E) verteilt sind, wobei die lichtemittierende Vorrichtung für wenigstens einen Teil der Anordnungen (E) wenigstens zwei Halbleiterbereiche (19, 44, 19', 44') aufweist, die erste und zweite Photodioden (PH, PH') bilden, wobei jeder der beiden Halbleiterbereiche wenigstens teilweise mit einem zweiten Leitfähigkeitstyp entgegengesetzt zu dem ersten Leitfähigkeitstyp dotiert ist und sich im Substrat von einem zweiten Teil der ersten Oberfläche erstreckt, der sich vom ersten Teil unterscheidet, **dadurch gekennzeichnet, dass**
der Halbleiterbereich (19, 44) sich in dem Substrat von einem zweiten Teil der ersten Oberfläche erstreckt, der sich von dem ersten Teil unterscheidet; dass
der Halbleiterbereich (19, 44) mit einem Farbfilter (72) abgedeckt ist; und dass
die ersten und zweiten Photodioden (PH, PH') unterschiedliche Übergangs- oder Verbindungstiefen aufweisen und/oder mit Filtern unterschiedlicher Farbe (72, 72') bedeckt sind.

2. Lichtemittierende Vorrichtung nach Anspruch 1, wobei jedes dreidimensionale Halbleiterelement (20) hauptsächlich aus einer Verbindung hergestellt ist, die aus der Gruppe ausgewählt ist, die III-V-Verbindungen und II-VI-Verbindungen aufweist.

3. Lichtemittierende Vorrichtung nach Anspruch 1 oder 2, wobei das Substrat (14) wenigstens teilweise aus einem Halbleitermaterial hergestellt ist, das aus der Gruppe ausgewählt ist, die Silizium, Germanium, Siliziumkarbid, III-V-Verbindungen oder ZnO aufweist.

4. Lichtemittierende Vorrichtung nach einem der Ansprüche 1 bis 3, wobei das Substrat (14) eine zweite Oberfläche (16) gegenüber der ersten Oberfläche aufweist, wobei die lichtemittierende Vorrichtung eine erste Elektrode (12; 48) in Kontakt mit der zweiten Oberfläche (16) oder mit der ersten Oberfläche (18) aufweist.

5. Lichtemittierende Vorrichtung nach Anspruch 4, die eine zweite Elektrode (26) aufweist, die wenigstens mit einigen der lichtemittierenden Dioden (DEL) in Kontakt steht, und eine dritte Elektrode (28), die mit dem Halbleiterbereich (19) auf der Seite der ersten Oberfläche (18) in Kontakt steht.

6. Lichtemittierende Vorrichtung nach einem der Ansprüche 1 bis 5, wobei die lichtemittierenden Dioden (DEL) mit einer Schicht (29) abgedeckt sind, die Phosphor aufweist, und wobei der Halbleiterbereich (19, 44) nicht mit der Schicht abgedeckt ist, die Phosphor aufweist.

7. Lichtemittierende Vorrichtung nach einem der Ansprüche 1 bis 6, wobei der Halbleiterbereich (19, 44) durch Ionenimplantation von Dotierstoffen gebildet ist.

8. Lichtemittierende Vorrichtung nach einem der Ansprüche 1 bis 6, wobei der Halbleiterbereich (19, 44) durch Epitaxie gebildet ist.

9. Lichtemittierende Vorrichtung nach einem der Ansprüche 1 bis 8, wobei die lichtemittierenden Dioden (DEL) in Anordnungen von lichtemittierenden Dioden (E1, E2, E3, E4) verteilt sind, wobei sich der Halbleiterbereich (19, 44) zwischen den beiden Anordnungen befindet.

10. Lichtemittierende Vorrichtung nach einem der Ansprüche 1 bis 9, die eine Schaltung (104) zum Verarbeiten erster Signale aufweist, die von der Photodiode (PH) geliefert werden, und eine Schaltung (102) zum Steuern der lichtemittierenden Dioden (DEL) über zweite Signale, die von der Verarbeitungsschaltung geliefert werden.

11. Lichtemittierende Vorrichtung nach Anspruch 10 in ihrer Abhängigkeit von Anspruch 9, wobei die Steuerschaltung (102) in einer Kalibrierungsphase geeignet ist, jede Anordnung von lichtemittierenden Dioden (E1, E2) nacheinander einzuschalten, wobei die Verarbeitungsschaltung geeignet ist, die von der Photodiode (PH) aufgenommene Strahlung zu messen, wenn jede Anordnung von lichtemittierenden Dioden eingeschaltet ist.

## Claims

1. A light-emitting device (10; 40; 60; 70; 80; 85; 90) comprising:
an at least partially doped substrate (14) of a first conductivity type, comprising a first surface (18);
light-emitting diodes (DEL) each comprising at least one non-doped or doped three-dimensional semiconductor element (20) of the first conductivity type, the three-dimensional semiconductor elements (20) resting on a first continuous portion (30) of the first surface, the three-dimensional semiconductor elements (20) being nanowires, microwires, and/or nanometer- or micrometer-range pyramidal structures; and
at least one at least partially doped semiconductor region (19, 44) forming a photodiode (PH), of a second conductivity type opposite to the first conductivity type,
wherein the light-emitting diodes (DEL) are distributed in assemblies of light-emitting diodes (E), the light-emitting device comprising, for at least some of the assemblies (E), at least two semiconductor regions (19, 44, 19', 44') forming first and second photodiodes (PH, PH'), each of the two semiconductor regions being at least partially doped with a second conductivity type opposite to the first conductivity type and extending in the substrate from a second portion of the first surface different from the first portion, **characterized in that**
the semiconductor region (19, 44) extends in the substrate from a second portion of the first surface different from the first portion; **in that**
the semiconductor region (19, 44) is covered with a colored filter (72); and **in that**
the first and second photodiodes (PH, PH') have different junction depths and/or being covered with filters of different colors (72, 72').

2. The light-emitting device of claim 1, wherein each three-dimensional semiconductor element (20) is mainly made of a compound selected from the group comprising III-V compounds and II-VI compounds.

3. The light-emitting device of claim 1 or 2, wherein the substrate (14) is at least partly made of a semiconductor material selected form the group comprising silicon, germanium, silicon carbide, III-V compounds, or ZnO.

4. The light-emitting device of any of claims 1 to 3, wherein the substrate (14) comprises a second surface (16) opposite to the first surface, the light-emitting device comprising a first electrode (12; 48) in contact with the second surface (16) or with the first surface (18).

5. The light-emitting device of claim 4, comprising a second electrode (26) in contact at least with some of the light-emitting diodes (DEL) and a third electrode (28) in contact with the semiconductor region (19) on the side of the first surface (18) .

6. The light-emitting device of any of claims 1 to 5, wherein the light-emitting diodes (DEL) are covered with a layer (29) comprising phosphors and wherein the semiconductor region (19, 44) is not covered with said layer comprising phosphors.

7. The light-emitting device of any of claims 1 to 6, wherein the semiconductor region (19, 44) is formed by ion implantation of dopants.

8. The light-emitting device of any of claims 1 to 6, wherein the semiconductor region (19, 44) is formed by epitaxy.

9. The light-emitting device of any of claims 1 to 8, wherein the light-emitting diodes (DEL) are distributed in assemblies of light-emitting diodes (E1, E2, E3, E4), said semiconductor region (19, 44) being located between the two assemblies.

10. The light-emitting device of any of claims 1 to 9, comprising a circuit (104) for processing first signals supplied by the photodiode (PH) and a circuit (102) for controlling the light-emitting diodes (DEL) from second signals supplied by the processing circuit.

11. The light-emitting device of claim 10 in its dependence on claim 9, wherein the control circuit (102) is capable, in a calibration phase, of successively turning on each assembly of light-emitting diodes (E1, E2), the processing circuit being capable of measuring the radiation captured by the photodiode (PH) when each assembly of light-emitting diodes is on.
